(19) Europäisches Patentamt
European Patent Office
Office européen des brevets

(11) **EP 4 478 063 A1**

(12) **EUROPEAN PATENT APPLICATION**

(43) Date of publication:
**18.12.2024 Bulletin 2024/51**

(21) Application number: **23179498.3**

(22) Date of filing: **15.06.2023**

(51) International Patent Classification (IPC):
**G01R 29/08** (2006.01)    **G01R 33/032** (2006.01)
**G01R 33/12** (2006.01)

(52) Cooperative Patent Classification (CPC):
**G01R 29/0885; G01R 33/26**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Österreichische Akademie der
Wissenschaften
1010 Wien (AT)**

(72) Inventor: **Trupke, Michael
1010 Wien (AT)**

(74) Representative: **Louis Pöhlau Lohrentz
Patentanwälte
Merianstrasse 26
90409 Nürnberg (DE)**

(54) **APPARATUS FOR CHARACTERISING A SIGNAL, METHOD OF CHARACTERISING A SIGNAL**

(57)     Disclosed are a method and apparatus (10) for analysing an input signal using measurements of a property of a material (12) dependent on a population in at least one of first, second, and third energy levels within the material (12). Direct transitions are permitted between the first and third levels and between the second and third levels, but not between the first and second levels. The method comprises applying to the material (12) an input signal driving transitions between the first and third levels, and control signals with differing frequencies driving transitions between the second and third levels, measuring the property, determining for each control signal a transition probability between the first and second levels under application of the input and control signal using the measurements, and calculating the amplitude and/or frequency of the input signal using the probabilities. Also provided are a method and apparatus (10) for measuring magnetic field strength using the same principles.

Fig. 1

EP 4 478 063 A1

**Description**

**Introduction**

The present invention relates to methods and apparatuses for characterising a signal. It is applicable in particular to determining the frequency, amplitude, and phase of microwave-frequency electromagnetic signals.

It is desirable in a variety of fields, such as telecommunications and radar systems, to be able to rapidly and precisely determine the properties of an incoming electromagnetic signal. In telecoms, many of the multiple frequency bands and signal shapes in use (for example Wi-Fi or 5G networks) must be detected and distinguished. In radar technology, it is desirable to be able to rapidly and selectively analyse signals over a wide detection band to determine the position and speed of objects such as aircraft. Typically, the properties of an incoming signal are determined using a signal analyser in one of two ways.

In a first approach, the input signal is mixed with a "local oscillator" signal with known and variable properties, and the resulting mixed signal is analysed. The frequency of the local oscillator signal is then swept to determine the frequency content and other properties of the input signal over a range of different frequencies. In the second approach, the input signal may be digitised using an analogue-to-digital converter (ADC), and subjected to digital signal analysis such as a fast-Fourier transform (FFT) to determine its properties over a range of frequencies.

Sweeping a local oscillator can allow the signal to be analysed over a wide frequency band, but has the disadvantage that the analyser is only sensitive to a narrow range of frequencies at any given time in the sweep cycle. This means transient features of a signal may be missed. ADC-based analysis is less likely to miss transient features, but requires high sampling rates to adequately resolve the input signal. Heterodyne downconversion can be used to analyse higher-frequency input signals, but limits on ADC sampling rates will still limit the bandwidth over which the input signal can be analysed, or may make a digitisation-based approach entirely impractical. These limitations of scanning and ADC-based approaches can be a problem if the input signal has an unknown frequency within a relatively wide band, and has short-lived features of interest, because the limited instantaneous bandwidth of both approaches may lead to missing features of the input signal entirely.

A further approach uses gradient-based methods relying on the application of a magnetic field gradient to provide variable energy level splitting in different regions of a material. Such an approach can be implemented, for example, using paramagnetic defects in crystal. One such realization has been demonstrated using nitrogen-vacancy (NV) centres in diamond. The frequency of an input signal can be determined in this approach from where its frequency matches the energy level splitting, and therefore causes an observable effect as it drives the transition. In this approach, the resolution is limited by the product of the magnetic field gradient (T/m) and the spatial resolution of the system (pixel size, m). The product must furthermore be convolved with the linewidth of the paramagnetic centres. Applying a precise and stable magnetic field gradient can be difficult, particularly when a steep gradient is desirable to provide a relatively wide bandwidth. Therefore, such methods often introduce substantial errors due to uncertainty in the magnetic field gradient.

Paramagnetic defects in diamond, and other analogous systems can also be used to sense magnetic fields (L Rondin et al, 2014 Rep. Prog. Phys. 77 056503). However, a practical, scalable implementation of such a sensor is still needed.

**Summary of Invention**

It is therefore desirable to provide an apparatus and method for analysing signals that can rapidly obtain a determination of multiple properties of input signals over a wide bandwidth. It is also desirable to provide an improved system for measuring magnetic fields. It is an object of the invention to provide such systems.

According to an aspect of the invention, there is provided a method of analysing an input signal using measurements of a property of a material, wherein the property of the material is dependent on a population in at least one of a first energy level, a second energy level, and a third energy level within the material, direct transitions are permitted between the first energy level and the third energy level, direct transitions are permitted between the second energy level and the third energy level, and direct transitions are not permitted between the first energy level and the second energy level, the method comprising applying the input signal to the material, the input signal driving transitions between the first energy level and the third energy level, applying a plurality of control signals to the material, each control signal having a frequency different from the frequencies of the other control signals, the control signals driving transitions between the second energy level and the third energy level, measuring the property of the material, determining a transition probability for each control signal using the measurements of the property of the material, the transition probability being a probability of transitions between the first energy level and the second energy level under application of the input signal and the control signal, and calculating the amplitude and/or frequency of the input signal using the plurality of transition probabilities.

By applying a plurality of control signals with different frequencies to the material, and determining the transition probabilities for each control signal, the signal can be analysed at a plurality of frequencies simultaneously, and without requiring high-frequency digitisation of the input signal. Therefore, a characterisation of the input signal can be obtained more quickly than with conventional signal analysers.

In some embodiments, the property of the material is photoluminescence. Photoluminescence can be rapidly and robustly measured, so is well-suited to this application and the types of materials used.

In some embodiments, the property of the material is photoconductivity. Photoconductivity can be rapidly and robustly measured, so is well-suited to this application and the types of materials used.

In some embodiments, the material is a crystalline material, preferably a diamond crystal containing nitrogen-vacancy centres. Such materials are well-understood and convenient for integration in a solid-state sensor apparatus.

In some embodiments, the population is a population of electrons, and the transitions are transitions of electrons. Excitation of electrons in paramagnetic defects such as the nitrogen vacancy centre can be achieved in convenient frequency ranges.

In some embodiments, the input signal has a frequency that differs from a first transition frequency between the first energy level and the third energy level by at most a first predetermined value. If the difference between the input signal frequency and first transition frequency is too large, then the transition probability may be too low to easily detect. Tuning the first transition frequency to within a predetermined value of the expected input signal frequency can thereby improve the detection of the input signal.

In some embodiments, the frequency of each of the plurality of control signals differs from a second transition frequency between the second energy level and the third energy level by at most a second predetermined value. As for the input signals, if the control signal frequency is too different from the second transition frequency, it may become difficult to measure the transition probability. Therefore, it is desirable to keep the control signal frequencies within a predetermined range of the second transition frequency.

In some embodiments, the input signal and/or the control signals are microwave-frequency signals. Microwave-frequency signals are particularly suited for the range of transition frequencies that are easily accessible in the types of materials used.

In some embodiments, applying the input signal to the material comprises splitting the input signal into a plurality of amplified input signals, each amplified input signal being amplified by an amplification factor relative to the input signal, the amplification factor being different for each amplified input signal, and applying the plurality of amplified input signals to the material. This approach allows the amplitude of the input signal to be determined more rapidly using the simultaneous measurements of the interaction of the input signal and control signal at multiple amplification factors.

In some embodiments, the plurality of control signals are applied to a respective plurality of sensing regions of the material, and measuring the property of the material comprises measuring the property of the material in each of the sensing regions. Using a plurality of sensing regions allows the different combinations of control and input signals to be readily identified when measuring the property of the material.

In some embodiments, the application of the plurality of control signals and the plurality of amplified input signals is performed such that the combination of the frequency of the control signal and the amplification factor of the amplified input signal is different for each sensing region. This maximises the information available when calculating the amplitude and/or frequency of the input signal from the transition probabilities, thereby improving the accuracy and reliability of the determined amplitudes and frequencies.

In some embodiments, applying the input signal to the material comprises applying the input signal to one or more input lines on the material, and applying the plurality of control signals to the material comprises applying the control signals to a respective plurality of control lines on the material. Using physical input and control lines provides a convenient way to apply the signals to specified areas of the material and provide different combinations of the input and control signals.

In some embodiments, the method further comprises, prior to applying the input signal and the plurality of control signals, creating a population imbalance between the first energy level and the second energy level. Creating a population imbalance between the first and second energy levels allows the detection of a transfer of population between the two levels by detecting a change in the direction of the imbalance. This in turn allows the transition probability to be determined.

In some embodiments, creating the population imbalance between the first energy level and the second energy level comprises transferring a first population into one of the first energy level and the second energy level. Transferring a population into one of the first and second energy levels allows the transition probability to be determined by determining what proportion of the population is transferred to the other of the first and second energy levels by the combination of input and control signals.

In some embodiments, transferring the first population into one of the first energy level and the second energy level comprises optically exciting a second population into an excited state. Optical excitation can be performed robustly and with a high degree of control.

In some embodiments, the frequencies of the plurality of control signals and the frequency of the input signal are spectrally distinct from a frequency of light used to optically excite electrons in the material. This ensures that the control signals and input signals do not drive excitation of electrons between energy levels other than the first or second to third levels, which could introduce error into the determination of transition probabilities.

In some embodiments, transferring the first population into one of the first energy level and the second energy level further comprises, following the optical excitation of the second population, transferring the first population from the third energy level into the one of the first energy level and the second energy level. This allows transfer of population between states with a different energy scale of splitting than when initially optically exciting the second population. In some embodiments, the transferring of the first population is performed using a microwave pulse.

In some embodiments, the property of the material is dependent on the population in the third energy level, and measuring the property of the material comprises, following application of the input signal and the plurality of control signals, transferring a third population from the other of the first energy level and the second energy level to the third energy level. This allows the robust detection of a population transferred between the first and second levels, by subsequently transferring that population back to a directly observable energy level. In some embodiments, the transferring of the third population is performed using a microwave pulse.

In some embodiments, the property of the material is photoluminescence, and measuring the property of the material comprises measuring an intensity of light emitted from the material. Photoluminescence can be conveniently measured over an area of the material for the various control signals, for example using a photodetector.

In some embodiments, the property of the material is photoconductivity, applying the plurality of control signals to the material comprises applying the control signals to a respective plurality of control lines on the material, and measuring the property of the material comprises measuring a photocurrent induced in the control lines. Measuring the photocurrent simplifies the device as a separate photodetector is not required. The photocurrent can be measured using dedicated leads, or using the control and input lines Using the lines to also measure the photoconductivity allows the lines to perform a dual function, thereby further simplifying the apparatus.

In some embodiments, the control signals and/or the input signal are pulsed. This can allow for variation of the properties of the input and control signal in order to varying the detected signals, for example, to improve contrast or gain.

In some embodiments, measuring the property of the material comprises measuring the property of the material between pulses of the control signals and/or the input signal. This allows measurements to be made without interference from the control and/or input signals.

In some embodiments, determining the transition probability for each control signal comprises determining, using the measurements of the property of the material, a final population in one of the first energy level and the second energy level following application of the input signal and the plurality of control signals. In some embodiments, the final population is determined as a proportion of an initial population in the other of the first energy level and the second energy level prior to application of the input signal and the control signal. In some embodiments, the transition probability for each control signal is determined using the final population.

In some embodiments, calculating the amplitude and/or frequency of the input signal comprises fitting to the plurality of determined transition probabilities a dependence of the transition probability on the amplitude and frequency of the input signal and on the amplitude and frequency of the control signal. Fitting a dependence to the determined transition probabilities will improve the accuracy of determination of the amplitude and/or frequency by taking into account the information from multiple measurements.

In some embodiments, the dependence of the transition probability P is given by:

$$P = \frac{\widetilde{\Omega}^2}{(\Delta_+ - \Delta_-)^2 + \widetilde{\Omega}^2} \sin^2\left(\frac{t}{2}\sqrt{(\Delta_+ - \Delta_-)^2 + \widetilde{\Omega}^2}\right)$$

wherein:

$$\widetilde{\Omega} = \frac{\Omega_+ \Omega_-}{\Delta_+ + \Delta_-}$$

and wherein $\Omega_+$ and $\Omega_-$ are the amplitudes of the input signal and control signal respectively, $\Delta_+$ is a difference between the frequency of the input signal and a first transition frequency between the first energy level and the third energy level, $\Delta_-$ is a difference between the frequency of the control signal and a second transition frequency between the second energy level and the third energy level, and t is a time for which both the input signal and the control signal are simultaneously applied to the material.

In some embodiments, the method further comprises, following the step of calculating the amplitude and/or frequency of the input signal, applying the input signal to the material, applying a plurality of phase control signals to the material, wherein each phase control signal (a) drives transitions between one of the first energy level and the second energy level, and the third energy level, (b) has a frequency that differs by a predetermined frequency difference from the calculated frequency of the input signal, and (c) has a phase shift different from a phase shift of any other phase control

4

signal, measuring the property of the material, determining a second transition probability for each phase control signal using the measurements of the property of the material, the second transition probability being a probability of transitions between the one of the first energy level and the second energy level, and the third energy level under application of the input signal and the phase control signal, and calculating the phase of the input signal using the plurality of second transition probabilities. Once the frequency of the input signal has been determined, further measurement steps can determine the phase of the input signal, which can provide additional useful information about the input signal and its information content.

In some embodiments, the predetermined frequency difference is zero. This results in a homodyne configuration of the phase measurement.

In some embodiments, applying the input signal to the material comprises applying the input signal to a plurality of input lines on the material, the input signal being phase shifted before application to each input line by a phase factor that is different for each input line. Similarly to applying varying amplification factors when determining frequency and/or amplitude, duplicating the input signal with different phase shifts provides additional information to fit and more reliably determine phase.

In some embodiments, the method further comprises applying a magnetic field to the material. The magnetic field causes splitting of the energy levels in the material, and varying the magnetic field can tune the splitting depending on the measurement to be made.

According to an aspect of the invention, there is provided an apparatus for analysing an input signal comprising: a material having a property dependent on a population in at least one of a first energy level, a second energy level, and a third energy level within the material, wherein direct transitions are permitted between the first energy level and the third energy level, direct transitions are permitted between the second energy level and the third energy level, and direct transitions are not permitted between the first energy level and the second energy level; a controller configured to apply the input signal to the material, the input signal driving transitions between the first energy level and the third energy level, and apply a plurality of control signals to the material, each control signal having a frequency different from the frequencies of the other control signals, the control signals driving transitions between the second energy level and the third energy level; a detector configured to measure the property of the material; and a processor configured to determine a transition probability for each control signal using the measurements of the property of the material, the transition probability being a probability of transitions between the first energy level and the second energy level under application of the input signal and the control signal, and calculate the amplitude and/or frequency of the input signal using the plurality of transition probabilities.

The method described above can be implemented using an embodiment of the apparatus for analysing an input signal.

According to a further aspect of the invention, there is provided a method of measuring a strength of a magnetic field applied to a material using measurements of a property of the material, wherein: the property of the material is dependent on a population in at least one of a first energy level, a second energy level, and a third energy level within the material; direct transitions are permitted between the first energy level and the third energy level; direct transitions are permitted between the second energy level and the third energy level; direct transitions are not permitted between the first energy level and the second energy level; and at least one of (a) a first transition frequency between the first energy level and the third energy level, and (b) a second transition frequency between the second energy level and the third energy level, is dependent on the strength of the magnetic field, the method comprising: applying the input signal to the material, the input signal driving transitions between the first energy level and the third energy level; applying one or more control signals, preferably a plurality of control signals, to the material, the control signals driving transitions between the second energy level and the third energy level; measuring the property of the material; determining a transition probability at each measurement position using the measurements of the property of the material, the transition probability being a probability of transitions between the first energy level and the second energy level under application of the input signal and the control signal; and calculating the strength of the magnetic field using the one or more transition probabilities. In some embodiments of measuring a strength of a magnetic field, the property of the material is photoluminescence. Photoluminescence can be rapidly and robustly measured, so is well-suited to this application and the types of materials used.

In some embodiments of measuring a strength of a magnetic field, the property of the material is photoconductivity. Photoconductivity can be rapidly and robustly measured, so is well-suited to this application and the types of materials used.

In some embodiments of measuring a strength of a magnetic field, the material is a crystalline material. In some embodiments of measuring a strength of a magnetic field, the material is a diamond crystal containing nitrogen-vacancy centres. Such materials are well-understood and convenient for integration in a solid-state sensor apparatus.

In some embodiments of measuring a strength of a magnetic field, the population is a population of electrons, and the transitions are transitions of electrons. Excitation of electrons in paramagnetic defects such as the nitrogen vacancy centre can be achieved in convenient frequency ranges.

In some embodiments of measuring a strength of a magnetic field, the input signal has a frequency that differs from the first transition frequency by at most a first predetermined value.

In some embodiments of measuring a strength of a magnetic field, the frequencies of the one or more control signals, preferably the plurality of control signals, differ from the second transition frequency by at most a second predetermined value.

In some embodiments of measuring a strength of a magnetic field, the input signal and/or the control signals are microwave-frequency signals. Microwave-frequency signals are particularly suited for the range of transition frequencies that are easily accessible in the types of materials used.

In some embodiments of measuring a strength of a magnetic field, applying the input signal to the material comprises: splitting the input signal into a plurality of amplified input signals, each amplified input signal being amplified by an amplification factor relative to the input signal, the amplification factor being different for each amplified input signal; and applying the plurality of amplified input signals to the material.

In some embodiments of measuring a strength of a magnetic field, the one or more control signals, preferably the plurality of control signals, are applied to respective sensing regions of the material; and measuring the property of the material comprises measuring the property of the material in each of the sensing regions. Using a plurality of sensing regions allows the different magnetic field strengths to be readily determined at multiple sites when measuring the property of the material.

In some embodiments of measuring a strength of a magnetic field, application of the one or more control signals, preferably the plurality of control signals, and the plurality of amplified input signals is performed such that the combination of the frequency of the control signal and the amplification factor of the amplified input signal is different for each sensing region.

In some embodiments of measuring a strength of a magnetic field, applying the input signal to the material comprises applying the input signal to one or more input lines on the material; and applying the one or more control signals, preferably the plurality of control signals, to the material comprises applying the control signals to respective control lines on the material. Using physical input and control lines provides a convenient way to apply the signals to specified areas of the material and provide different combination of the input and control signals.

In some embodiments of measuring a strength of a magnetic field, the method further comprises, prior to applying the input signal and the one or more control signals, preferably the plurality of control signals, creating a population imbalance between the first energy level and the second energy level. Creating a population imbalance between the first and second energy level allows the detection of a transfer of population between the two levels by detecting a change in the direction of the imbalance. This in turn allows the transition probability to be determined.

In some embodiments of measuring a strength of a magnetic field, creating the population imbalance between the first energy level and the second energy level comprises transferring a first population into one of the first energy level and the second energy level. Transferring a population into one of the first and second energy levels allows the transition probability to be determined by determining what proportion of the population is transferred to the other of the first and second energy levels by the combination of input and control signals.

In some embodiments of measuring a strength of a magnetic field, transferring the first population into one of the first energy level and the second energy level comprises optically exciting a second population into an excited state. Optical excitation can be performed robustly and with a high degree of control.

In some embodiments of measuring a strength of a magnetic field, the frequencies of the plurality of control signals and the frequency of the input signal are spectrally distinct from a frequency of light used to optically excite the second population. This ensures that the control signals and input signals do not drive excitation of electrons between energy levels other than the first or second to third levels, which could introduce error into the determination of transition probabilities.

In some embodiments of measuring a strength of a magnetic field, transferring the first population into one of the first energy level and the second energy level further comprises, following the optical excitation of the second population, transferring the first population from the third energy level into the one of the first energy level and the second energy level. This allows transfer of population between states with a different energy scale of splitting than when initially optically exciting the second population.

In some embodiments of measuring a strength of a magnetic field, the transfer of the first population is performed using a microwave pulse.

In some embodiments of measuring a strength of a magnetic field, the property of the material is dependent on the population in the third energy level, and measuring the property of the material comprises, following application of the input signal and the plurality of control signals, transferring a third population from the other of the first energy level and the second energy level to the third energy level. This allows the robust detection of a population transferred between the first and second levels, by subsequently transferring that population back to a directly observable energy level.

In some embodiments of measuring a strength of a magnetic field, the transfer of the third population is performed using a microwave pulse.

In some embodiments of measuring a strength of a magnetic field, the property of the material is photoluminescence, and measuring the property of the material comprises measuring an intensity of light emitted from the material. Photoluminescence can be conveniently measured over an area of the material for the various control signals, for example using a photodetector.

In some embodiments of measuring a strength of a magnetic field, the property of the material is photoconductivity; applying the one or more control signals, preferably the plurality of control signals, to the material comprises applying the control signals to respective control lines on the material; and measuring the property of the material comprises measuring a photocurrent induced in the control lines. Measuring the photocurrent simplifies the device as a separate photodetector is not required. The photocurrent can be measured using dedicated leads, or using the control and input lines using the lines to also measure the photoconductivity allows the lines to perform a dual function, thereby further simplifying the apparatus.

In some embodiments of measuring a strength of a magnetic field, the control signals and/or the input signal are pulsed. This can allow for variation of the properties of the input and control signal in order to vary the detected signals, for example, to improve contrast or gain.

In some embodiments of measuring a strength of a magnetic field, measuring the property of the material comprises measuring the property of the material between pulses of the control signals and/or the input signal. This allows measurements to be made without interference from the control and/or input signals.

In some embodiments of measuring a strength of a magnetic field, determining the transition probability for each control signal comprises determining, using the measurements of the property of the material, a final population in one of the first energy level and the second energy level following application of the input signal and the one or more control signals.

In some embodiments of measuring a strength of a magnetic field, the final population is determined as a proportion of an initial population in the other of the first energy level and the second energy level prior to application of the input signal and the control signal.

In some embodiments of measuring a strength of a magnetic field, whereby the transition probability for each control signal is determined using the final population.

In some embodiments of measuring a strength of a magnetic field, calculating the strength of the magnetic field comprises fitting to the plurality of determined transition probabilities a dependence of the transition probability on (a) the amplitude and frequency of the input signal, (b) the amplitude and frequency of the control signal, and (c) the strength of the magnetic field.

In some embodiments of measuring a strength of a magnetic field, the dependence of the transition probability P is given by:

$$P = \frac{\widetilde{\Omega}^2}{(\Delta_+ - \Delta_-)^2 + \widetilde{\Omega}^2} \sin^2(\frac{t}{2}\sqrt{(\Delta_+ - \Delta_-)^2 + \widetilde{\Omega}^2})$$

wherein:

$$\widetilde{\Omega} = \frac{\Omega_+ \Omega_-}{\Delta_+ + \Delta_-}$$

and wherein $\Omega_+$ and $\Omega_-$ are the amplitudes of the input signal and control signal respectively, $\Delta_+$ is a difference between the frequency of the input signal and a first transition frequency between the first energy level and the third energy level, $\Delta_-$ is a difference between the frequency of the control signal and a second transition frequency between the second energy level and the third energy level, and $t$ is a time for which both the input signal and the control signal are simultaneously applied to the material.

In some embodiment of measuring a strength of a magnetic field, the measurement position is defined by the crossing point of the input signal and the control signal in the material. By that every position of the material can be measured in a targeted manner.

According to an aspect of the invention, there is provided an apparatus for measuring a magnetic field applied to a material having a property dependent on a population in at least one of a first energy level, a second energy level, and a third energy level within the material, wherein direct transitions are permitted between the first energy level and the third energy level, direct transitions are permitted between the second energy level and the third energy level, direct transitions are not permitted between the first energy level and the second energy level, and at least one of (a) a first transition frequency between the first energy level and the third energy level, and (b) a second transition frequency between the second energy level and the third energy level, is dependent on the strength of the magnetic field, the apparatus comprising: the material; a controller configured to apply the input signal to the material, the input signal driving transitions between the first energy level and the third energy level, and apply one or more control signals, preferably a plurality of control signals, to the material, the control signals driving transitions between the second energy level and the third energy level; a detector configured to measure the property of the material; and a processor configured to determine a transition probability for each control signal using the measurements of the property of the material, the transition probability being a probability of transitions between the first energy level and the second energy level under application of the input signal and the control signal, and calculate the strength of the magnetic field using the one or more transition probabilities.

The method described above can be implemented using an embodiment of the apparatus for analysing an input signal.

The principles underlying the analysis of the input signal can also be used to determine the properties of a magnetic field applied to the material if the characteristics of the input signal are known. This method can allow high precision and high resolution measurements of an unknown magnetic field using the properties of the material. The method of measuring a magnetic field may also be embodied in an apparatus, similar to the method of analysing an input signal discussed above.

## List of Figures

Embodiments of the invention will now be described, by way of example only, with reference to the accompanying drawings in which corresponding reference symbols indicate corresponding parts, and in which:

Fig. 1 is a schematic of an apparatus for analysing an input signal;
Fig. 2 is a simplified energy-level diagram for electrons within the material;
Fig. 3 shows the energy-level structure of the nitrogen-vacancy centre;
Fig. 4 is a flowchart of a method for analysing an input signal using the apparatus of Fig. 1;
Fig. 5 shows an example of a sequence of transfers of electron population where the input and control fields have the same detuning from their respective transition frequencies;
Fig. 6 shows an example of a sequence of transfers of electron population where the input and control fields have different detunings from their respective transition frequencies;
Fig. 7 shows an example of transition probabilities for a coarse frequency spacing of control signals;
Fig. 8 shows an example of transition probabilities for the same input signal as in Fig. 7, but with a finer spacing of control signal frequencies;
Fig. 9 shows a flowchart of steps involved in determining the phase of the input signal; and
Fig. 10 shows an example of transition probabilities for determining the phase of the input signal.

## Detailed Description

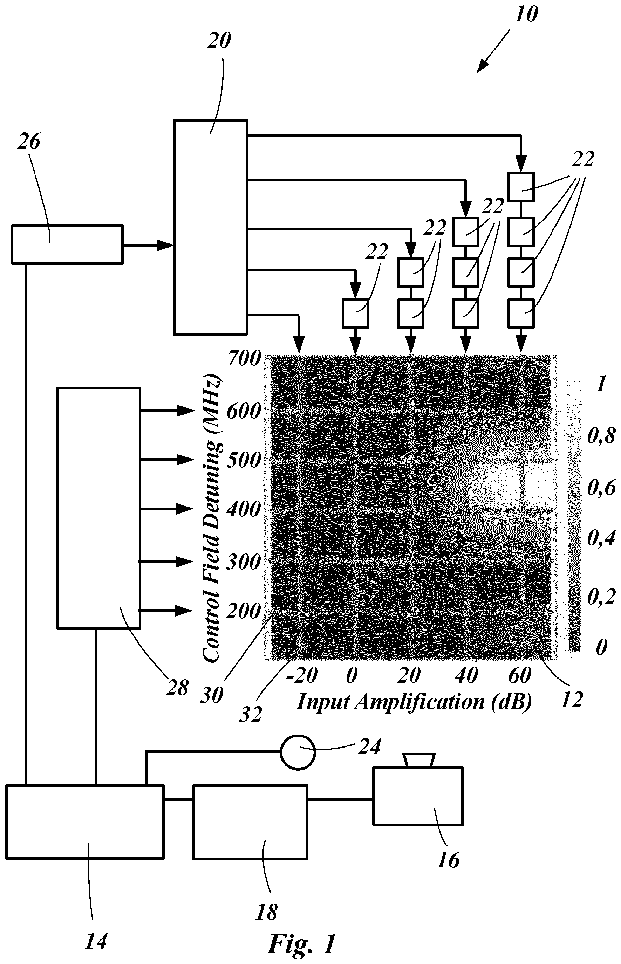

Fig. 1 shows an apparatus 10 for analysing an input signal according to an embodiment. The apparatus 10 is capable of fast, precise, and complete characterization of an electromagnetic input signal in terms of its frequency, amplitude, and phase. The apparatus 10 detects and identifies input signals in a known frequency range by means of an array (register) of physical systems which can undergo a transition driven by two or more electromagnetic fields. For example, the input signals may be microwave-frequency signals. The apparatus 10 and corresponding method enables a reconfigurable analysis device with high flexibility, and enables higher precision and resolution of the characteristics of the input signal than is possible with gradient-based methods. The apparatus 10 provides the basis for quantum-enhanced detection of electromagnetic fields using double-quantum transitions.

The apparatus 10 comprises a material 12 having a property dependent on a population in at least one of a first energy level, a second energy level, and a third energy level within the material 12. In Fig. 1, a graph of an example measurement result is superimposed over the material 12, which will be discussed in further detail below. The material 12 comprises an array of atom-like systems with three or more energy levels within the material. The apparatus 10 uses two-field transitions for input signal detection, and the material 12 can comprise any physical system with more than two energy levels coupled by electromagnetic fields in a lambda, V, or ladder-type configuration. Preferably, the material 12 is a crystalline material. Using a material in the solid state makes handling and construction of the apparatus 10 more straightforward.

The energy levels can be any energy levels that exhibit the required structure and whose population affects a measurable property of the material 12. In the detailed example discussed further below, the energy levels are electron energy levels in the material 12. In this case, the populations are populations of electrons, and the transitions are transitions of electrons. However, the same principles are applicable to other energy levels having the required structure. For example, in other embodiments, the energy levels may be nuclear energy levels, the populations may be populations of nuclear spins, and the transition may be transitions of nuclear spins. In still another embodiment, the energy levels may be vibrational energy levels.

In the example of Fig. 1, the material 12 is a diamond crystal containing nitrogen-vacancy (NV) centres. In particular, a diamond chip containing a shallow ensemble of NV centres is used. The NV centre consists of a defect in the diamond lattice comprising a substitutional nitrogen atom and an adjacent vacancy in the diamond lattice. NV centres are particularly preferred due to their long spin-coherence lifetimes. In an NV centre, the electron spin couples weakly to the vibrations of its host lattice, giving the defect a comparatively long spin lifetime. In normal diamonds, the spin quantum coherence can last for several microseconds, limited by the fluctuating magnetic field of residual $^{13}$C nuclei (spin 1/2). In isotopically purified diamond crystals, consisting only of spin-0 $^{12}$C atoms, it can reach lifetimes exceeding a millisecond when protected by decoupling pulse sequences. It was found very early on that the NV centre is a paramagnetic defect, the optical activity of which is linked to its magnetic spin state.

It is not essential to use NV centres, and other materials may be used. For example, other systems having a suitable multilevel ground state exist in silicon carbide, such as the divacancy. The apparatus 10 could also be used to identify input signals in the optical domain, using atomic gases as the material 12. NV centres have an energy level structure with spacings that are suited to detection of input signals with frequencies in the microwave regime. However, the apparatus 10 and corresponding method can readily be adapted to other frequency ranges, or to use materials with more levels and transitions.

In the example of Fig. 1, the property of the material 12 dependent on a population of electrons is photoluminescence, in particular fluorescence. However, in other embodiments, other properties, such as physical or optical properties, of the material 12 may be used.

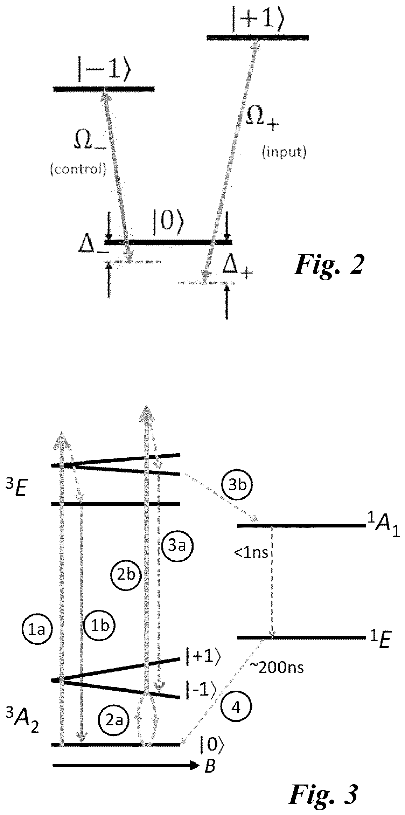

Fig. 2 shows a schematic of the energy-level structure within the material 12. The three energy levels are the first energy level $|+1\rangle$, the second energy level $|-1\rangle$, and the third energy level 10). Although in this example, the first energy level is the $m_s = 1$ state, and the second energy level is the $m_s = -1$ state, this is not essential, and in other embodiments, the first energy level may be the $m_s = -1$ state and the second energy level may be the $m_s = 1$ state. The three energy levels have a lambda- or V-shaped configuration, depending on the energy spacing between the first energy level $|+1\rangle$ and the third energy level 10), and between the second energy level $|-1\rangle$ and the third energy level 10). In this example, the property of the material 12 is dependent on the population of electrons in the third energy level 10). As shown by the two arrows in Fig. 2, direct transitions of electrons are permitted between the first energy level $|+1\rangle$ and the third energy level 10), and direct transitions of electrons are permitted between the second energy level $|-1\rangle$ and the third energy level 10). However, direct transitions of electrons are not permitted between the first energy level $|+1\rangle$ and the second energy level $|-1\rangle$. Populations of electrons in the three-level system in can be transferred indirectly between the first energy level $|+1\rangle$, the second energy level $|-1\rangle$, which are not connected by a direct transition, using two applied electromagnetic fields. The method may comprise applying a magnetic field to the material 12. Where, as in the present example, the first, second, and third energy levels are spin-triplet states, the magnetic field causes splitting of the triplet states, which are otherwise degenerate. However, depending on the material 12 used, in some embodiments it may not be necessary to apply a magnetic field for the first, second, and third energy levels to have different energies.

The negatively charged NV centre is a two-electron system, giving it a spin-1 ground state. Consequently, in the apparatus 10 of Fig. 1, where the material 12 is a diamond crystal comprising NV centres, the energy level structure shown in Fig. 2 correspond to the spin triplet ground state. The electronic $m_s = 0$ state, is denoted by 10). At room temperature, the transition $|0\rangle \leftrightarrow |\pm 1\rangle$ in the NV centre has a resonance frequency of 2.87 GHz. A magnetic field along the NV axis will split the $|\pm 1\rangle$ states, shifting the resonance frequency of each state to 2.87 GHz $\pm 28$ GHz/T, i.e. by 2.8 MHz/Gauss. Conveniently, the NV centre is spin-polarized by illumination with a green laser into state 10). The favourable properties of the optical cycle of the NV centre enable optical polarization and readout with a simple pulsed laser diode, even at room temperature.

Fig. 3 shows greater detail of the optical transitions within the NV centre. The NV centres can be initialized in any chosen population with a combination of laser and microwave pulses. Excitation (1a) of the NV centre from its 10) state will most often lead to direct luminescence decay (1b) back into the 10) ground state, which can be recorded by a photon counter. If a microwave drive (~3GHz) is set on resonance with e.g. the $|0\rangle \leftrightarrow |-1\rangle$ transition, as illustrated by the dashed arrows (2a) in Fig. 3, it will lead to a transfer of population from 10) to $|-1\rangle$. Optical excitation from the $|\pm 1\rangle$ ground states to the corresponding excited states (2b) will also lead to some luminescence (3a), but approximately half of the time, the electrons will decay (3b) into a long-lived metastable state. In this case, reduced luminescence is recorded. Following this decay, the system falls back into the 10) ground state (4). This leads to optical spin polarization, as optical excitation of sufficient duration will lead to the electron populations being directed into the $m_s = 0$ state, rather than being thermally distributed between the three triplet states.

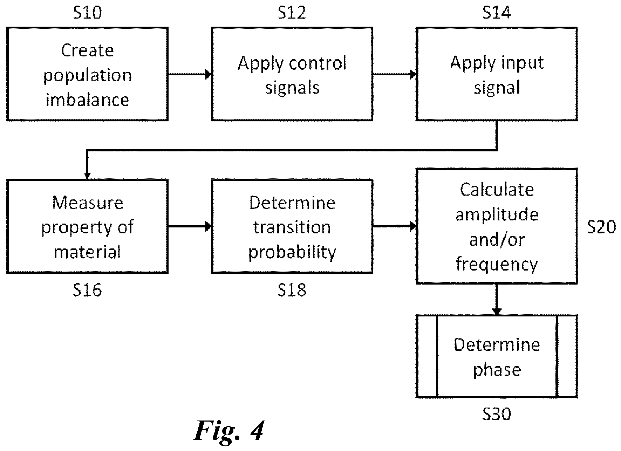

The apparatus 10 is used to carry out the method shown in the flowchart of Fig. 4. The method comprises a step S10 of, prior to applying the input signal and the plurality of control signals, creating a population imbalance between the first energy level and the second energy level. In a preferred embodiment, this is achieved by transferring a first population into one of the first energy level and the second energy level. In the examples of Figs. 2 and 3, this comprises transferring electrons from 10) to one of $|\pm 1\rangle$, although in general any mechanism for creating an imbalance could be used. For the apparatus 10 in Fig. 1, this initialises the NV centres of the material 12 over its entire area in one of $|\pm 1\rangle$. In the apparatus

10, the controller 14 is configured to perform the step S10.

Initially, a population of electrons is transferred into the third energy level, which in the NV centre is the ground state 10). This comprises spin polarising the electrons as described above. In accordance with the cycle described above, the step S10 of transferring the first population into one of the first energy level and the second energy level comprises optically exciting a second population into an excited state. This optical excitation causes the electrons to preferentially decay into the third energy level, i.e. the $m_s = 0$ state, leading to spin polarisation. Optically exciting the electrons may comprise using a laser 24 to illuminate a region of the material 12. In the apparatus 10, the controller 14 controls the laser 24 to illuminate the material 12.

When the laser pulse is applied, the luminescence measured when the material 12 is prepared in the $|0\rangle$ state will initially be brighter than that measured if the material 12 is prepared in the $|\pm 1\rangle$ ground states. This is because, as mentioned above, a significant proportion of decays from the $m_s = \pm 1$ excited states are to a singlet state and do not involve photoemission, while almost all decays from the $m_s = 0$ excited state involve photoemission. As illumination continues, the luminescence measured when the material 12 is prepared in the $|\pm 1\rangle$ ground states converges to the level of the material 12 when prepared in the 10) state. This is because of the cycle described above, wherein the decays from the excited states preferentially channel electrons into the $|0\rangle$ state. If the material is illuminated for a sufficiently long time, the system will be initialized with most electrons in state 10).

Transferring the first population into one of the first energy level and the second energy level further comprises, following the optical excitation of the second population, transferring the first population from the third energy level into the one of the first energy level and the second energy level. This transfer may be performed using a microwave pulse, in particular where the first population is a population of electrons. However, other types of radiation may be used where the population is of another type, e.g. nuclear spins or phonons.

Since the population is mostly transferred to the third energy level 10) by illumination, a microwave pulse is needed to transfer the electrons of the NV centre into the chosen one of the first energy level | + 1) and the second energy level | - 1). Preferably, the microwave pulse has a frequency that matches the transition frequency between the third energy level and the one of the first energy level and the second energy level (i.e. the first or second transition frequency). Preferably, the microwave pulse is a so-called $\pi$-pulse, with a duration chosen to completely transfer the electrons from the third energy level to the one of the first and second energy levels. This duration will depend on the amplitude of the microwave pulse. The microwave pulse may be applied by the controller 14 using a signal generator 28, which may be the same signal generator 28 used to apply the control signals, as will be described in more detail below.

The method comprises a step S14 of applying the input signal to the material 12. The input signal drives transitions between the first energy level and the third energy level, similarly to the microwave pulse used in step S10. The input signal is preferably a microwave-frequency signal. The controller 14 is configured to apply the input signal to the material 12. This may be achieved using a receiver 26, such as an antenna, that receives the input signal. The controller 14 may be configured to control the receiver 26 in order to selectively apply the input signal, for example using a switch incorporated into the receiver 26. In the apparatus 10, applying the input signal to the material 12 comprises applying the input signal to one or more input lines 32 on the material 12. This provides a convenient way to localise the application of the input signal to a particular region or regions of the material 12. In Fig. 1, the apparatus 10 has five input lines 32, but in general the apparatus 10 may comprise any number of input lines 32. The input lines 32 are in the form of wires extending across the material 12, however, in general they may take any suitable form. The input signal has a frequency $\Omega_+$ that differs from a first transition frequency between the first energy level and the third energy level by at most a first predetermined value. As shown in Fig. 2, the difference between the input signal frequency $\Omega_+$ and the first transition frequency, also referred to as the detuning of the input signal, is denoted $\Delta_+$. The probability of the population transitioning between the first and third energy levels will depend on the amplitude of the input signal and the size of the detuning $\Delta_+$.

Because the probability of transition between the first and third energy levels depends on the amplitude of the input signal, additional information can be obtained by applying copies of the input signal at different amplifications. In Fig. 1, the apparatus 10 comprises a splitter 20, which splits the input signal into a plurality of copies, some of which are amplified by amplifiers 22. Thereby, the step S14 of applying the input signal to the material 12 comprises splitting the input signal into a plurality of amplified input signals, and applying the plurality of amplified input signals to the material 12. Each amplified input signal is amplified by an amplification factor relative to the input signal, the amplification factor being different for each amplified input signal.

The method comprises a step S12 of applying a plurality of control signals to the material 12. The control signals drive transitions between the second energy level and the third energy level. The control signals are preferably microwave-frequency signals. Each control signal has a frequency $\Omega_-$ different from the frequencies of the other control signals. In the apparatus 10, the controller 14 is configured to apply a plurality of control signals to the material 12 using the signal generator 28. In the apparatus 10, applying the plurality of control signals to the material 12 comprises applying the control signals to a respective plurality of control lines 30 on the material 12. In Fig. 1, the apparatus 10 has five control lines 30, but in general the apparatus 10 may comprise any number of control lines 30. The control lines 30 are in the form of wires extending across the material orthogonal to the input lines 32, but in general may have any suitable shape.

The plurality of control signals are applied to a respective plurality of sensing regions of the material 12. The sensing regions comprise regions of the material 12 around each intersection of the input and control lines 32, 30. Each sensing region may comprise a plurality of the physical systems that provide the first, second, and third energy levels. For example, where the material 12 is a diamond crystal comprising NV centres, each sensing region may comprise a plurality of NV centres. In general, the application of the plurality of control signals and the plurality of amplified input signals is performed such that the combination of the frequency of the control signal and the amplification factor of the amplified input signal is different for each sensing region, although this is not essential. The frequency $\Omega_-$ of each of the plurality of control signals differs from a second transition frequency between the second energy level and the third energy level by at most a second predetermined value. As shown in Fig. 2, the difference between the control signal frequency $\Omega_-$ and the second transition frequency, also referred to as the detuning of the control signal, is denoted $\Delta_-$. Similarly as for the input signal, the probability of the electrons transitioning between the second and third energy levels will depend on the amplitude of the control signal and the size of the detuning $\Delta_+$. The power of the control signal therefore forms an additional control variable in addition to the choice of frequencies for the plurality of control signals.

As shown in Fig. 1, the material 12 is equipped with a grid of two sets of orthogonal wires. These wires provide the input lines 32 and control lines 30 mentioned above. The control and input lines 30, 32 are separated by an insulating layer to prevent electrical interference between the input and control signals. The control and input lines 30, 32 address rows and columns, respectively. In other embodiments, the control and input lines 30, 32 may be reversed and address columns and rows respectively. It is preferable that the control and input lines 30, 32 are orthogonal to one another to reduce interaction between the input and control signals. However, it is not essential, and the apparatus can still be used with non-orthogonal lines. The spacing of the wires may be chosen to reduce cross-talk. Cross-talk can occur between neighbouring wires when they are in close proximity.

In some embodiments, the frequencies of the plurality of control signals and the frequency of the input signal are spectrally distinct from a frequency of light used to optically excite the second population. For example, the frequencies of the plurality of control signals and the frequency of the input signal may be at most 30%, preferably at most 20%, more preferably at most 10%, most preferably at most 5%, of the frequency of light used in the step S10 to optically the second population. This prevents the control and input signals driving transitions to the excited states, which would disrupt the populations and reduce the reliability of the determination of the properties of the input signal.

In some embodiments, the control signals and/or the input signal are pulsed. The control signals are preferably pulsed, for example in order that measurements of the property of the material 12 can be made between control signal pulses. However, where the input signal is also pulsed, the pulses of the control signals may be flat (i.e. square) and much longer than the input signal pulses, such that the control signals are quasi-continuous on the timescale of the input signal pulses. The length of the pulses forms a further control variable. Different combinations of pulse shapes, detuning, and power (for both the control signals and input signal) will lead to distinct patterns of detected signal on the material 12 when measuring the property of the material 12 in the various sensing regions. These parameters can therefore be used to optimise the output to suit the measurement parameters for a particular expected input signal.

For example, in some embodiments if the input signal is pulsed, the detection method can be optimized to detect certain pulse shapes of the input signal (e.g. Gaussian or $\sin^2$ wavelets) by tailoring the control pulse shape. If the shape of the input pulses is known, then an optimized control pulse can be devised to match the input pulses. If the shape of the input pulse is unknown, then a variety of control pulse shapes can be tried to find a control pulse shape that adequately matches the input pulse shape.

In Fig. 4, the step S14 of applying the input signal is performed after the step S12 of applying the control signal. In general, these steps may be performed in any order, or performed simultaneously. However, there must be a period of time during which both the input signal and control signals are simultaneously applied to the material 12. Preferably the control signals are switched on before the input signal is applied, and switched off after the input signal is no longer being applied. This improves detection efficiency by ensuring that measurements can be made for the entire duration of the input signal.

Following the application of the input signal and control signals to the material 12, the method comprises a step S16 of measuring the property of the material 12. Measuring the property of the material 12 comprises measuring the property of the material in each of the sensing regions. In the example of Fig. 1, the property of the material 12 is photoluminescence, and measuring the property of the material 12 comprises measuring an intensity of light emitted from the material 12. Where the property is fluorescence, an external light source such as the laser 24 may be used to stimulate light emission by the material 12. The apparatus 10 comprises an optical detector 16 configured to detect light emitted by the material 12, for example a charge-coupled device (CCD).

Alternatively, in other embodiments, the property of the material may be photoconductivity, which can be read out electrically. In such an embodiment, measuring the property of the material may comprise measuring a photocurrent induced in the control lines 30. Electrical readout may rely on spin-dependent photoionization, which leads to a spin-dependent photocurrent which has a spin-dependent behaviour similar to the emitted photons detected optically. Therefore, in general, electrical readout gives a similar signal as optical readout. An advantage of electrical readout is that the same wires used as the control lines 30 and input lines 32, or additional wires on the device, can be used to apply a bias voltage and measure the photocurrent in each sensing region, and the separate detector 16 is not required. Preferably, the wires used for measuring the photocurrent should make ohmic contact with the material 12, but this is not essential.

The step S16 of measuring the property of the material 12 may comprise, where the control signals and/or the input signals are pulsed, measuring the property of the material 12 between pulses of the control signals and/or the input signal.

Measurement of the property of the material 12 allows the readout of the populations in one or more of the energy levels in the material 12 following application of the input signal and control signals, because the property of the material 12 depends on the population in one or more of the first, second, and third energy levels.

Any suitable readout method can be used to determine the transfer of population between the first and second energy levels. In the example of Fig. 1, measurement of the luminescence of the material allows readout of the NV centre, based on spin-dependent luminescence due to the cycle of transitions described above. As discussed above, the two states $|\pm 1\rangle$ are more likely to decay to the metastable state via transitions that do not emit radiation at optical wavelengths. Therefore, the greater the population in the $|\pm 1\rangle$ states, the lower the luminescence that will initially be measured under laser illumination.

An exemplary readout scheme involves applying a sequence of pulses to the material. An initial laser pulse is applied to spin-polarise the electrons in the material 12 in the $|0\rangle$ state, as described above. Subsequently, a microwave pulse resonant with the $|0\rangle \leftrightarrow |+1\rangle$ transition is applied. This means the carrier frequency of the microwave pulse matches the first transition frequency between the third and first energy levels. A proportion of the electrons in the $|0\rangle$ state will be transferred to the $|+1\rangle$ state, depending on the amplitude and duration of the microwave pulse. Following the microwave pulse, a second laser pulse is applied. The initial luminescence measured during the second laser pulse will depend on the proportion of the electrons transferred to the $|+1\rangle$ state by the microwave pulse. Varying the duration of the microwave pulse leads to rotations of the state vector of the electron population between the two states $|0\rangle$ and $|+1\rangle$ (also known as Rabi oscillations), and causes a corresponding change in the initial luminescence measured during the second laser pulse. Therefore, using this method, by measuring the property of the material 12, it is possible to determine the proportion of electrons in the third energy level $|0\rangle$ in the material 12.

As described above, following the steps S10-S14, population will be transferred from the first energy level to the second energy level (or vice versa, depending on which of the first and second energy level the population was transferred into in step S10) via the third energy level under the influence of both the control signals and input signal. The proportion of the population transferred from the first energy level into the second energy level will depend on the properties of the control signals and input signals. Since the properties of the control signals are known, determining the proportion of the population transferred into the second energy level using the measurements of the property of the material 12 allows the properties of the input signal to be determined.

However, in the case of the NV centre, there is no difference in luminescence between the states $|+1\rangle$ and $|-1\rangle$ corresponding to the first and second energy levels respectively, which means that simply measuring the luminescence following application of the input and control signals will only provide information about the population in $|0\rangle$ versus not in $|0\rangle$, i.e. in either of $|\pm 1\rangle$. In order to determine the population transferred to state $|-1\rangle$, that population is transferred to $|0\rangle$ by application of another microwave pulse resonant with the $|-1\rangle \leftrightarrow |0\rangle$ transition, i.e. the second transition frequency. If the step S10 comprised transferring the first population into the second energy level, this will be reversed, i.e. the population transferred to the first energy level must be determined, and a microwave pulse with a frequency matching the first transition frequency should be applied. Therefore, the step S16 of measuring the property of the material 12 comprises, following application of the input signal and the plurality of control signals, transferring a third population from the other of the first energy level and the second energy level to the third energy level using a microwave pulse.

As when transferring the first population into the one of the first energy level and the second energy level from the third energy level, this microwave pulse is preferably a $\pi$-pulse such that all of the electrons in the other of the first energy level and the second energy level are transferred into the third energy level and vice versa. Thereby, following the pulse, the only electrons in the third energy level are those which were in the other of the first energy level and the second energy level after the application of the input signal and control signals. A laser pulse can then be used to measure the luminescence of the material 12 and determine what proportion of the electrons are in the third energy level versus not in the third energy level.

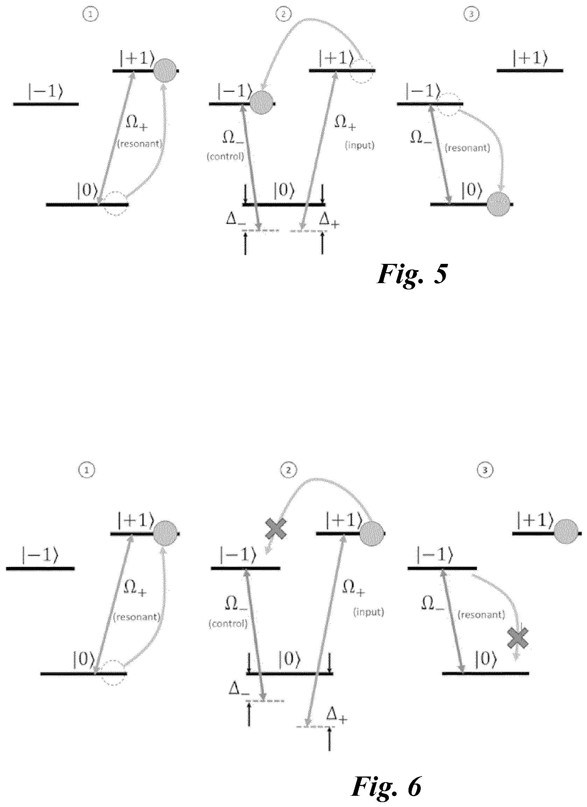

Two illustrative examples of the method are shown in Figs. 5 and 6. Step (1) of Fig. 5 shows step S10. After initialization of the material in the third energy level (state $|0\rangle$) using a relatively long laser pulse, the electron population is transferred entirely to one of the first energy level and the second energy level (in this example, the first energy level, state $|+1\rangle$) using a first microwave pulse resonant with the first transition frequency. Step (2) of Fig. 5 shows steps S12 and S14. The input signal and control signals are applied to the material. In this case, the control signal has the same detuning from the second transition frequency as does the input signal from the first transition frequency, such that $\Delta_+ = \Delta_-$. The control signal also has equal (or similar) power to the input signal. This causes the electron population to be transferred with high probability from the first energy level (state $|+1\rangle$) to the second energy level (state $|-1\rangle$). Finally, step (3) of Fig. 5 shows step S16. The electron population is transferred from the second energy level | - 1) to the third energy level 10) using a second microwave pulse resonant with the second transition frequency. This results in a bright signal when using a laser pulse to subsequently measure photoluminescence, or equivalently, a larger current in electrical readout.

Fig. 6 shows an example similar to the shown in Fig. 5. Step (1) of Fig. 6 is the same as step (1) of Fig. 5. However, in step (2) of Fig. 6, the input pulse has a different detuning from the first transition frequency than the control signal has from the second transition frequency, i.e. $\Delta_+ \neq \Delta_-$. Therefore, electrons are only transferred with very low probability between the first and second energy levels by the combination of the input signal and control signal and the transfer | + 1) $\rightarrow$ | - 1) does not take place. The electron population remains in the first energy level | + 1). Therefore, in step (3), following the second microwave pulse | - 1) $\rightarrow$ 10) there is little to no electron population in the third energy level. Since there is no population in the third energy level 10), a smaller photoluminescence signal is measured.

This process can be carried out simultaneously over all the sensing regions of the material 12 using the grid structure of the control lines 30 and input lines 32 for the simultaneous application of multiple control signal frequencies, input signal powers (and potentially phase values, as will be discussed further below). Thereby, it can rapidly be determined what amplitude and frequency matches the corresponding control signals in each sensing region from the luminescence measurements, and thereby determine the properties of the input signal.

Following the step S16 of measuring the property of the material 12, the method comprises a step S18 of determining a transition probability for each control signal using the measurements of the property of the material 12. The transition probability is a probability of transitions between the first energy level and the second energy level under application of the input signal and the control signal. A transition probability is determined for each sensing region, and so where the input signal is split and a plurality of amplified input signals applied, a transition probability is determined for each pairing of amplified input signal and control signal. The apparatus 10 comprises a processor 18 configured to determine the transition probabilities using the measurements from the detector 16 and the information about the control signal frequencies and input signal amplifications (where appropriate) from the controller 14.

Determining the transition probability for each control signal comprises determining, using the measurements of the property of the material 12, a final population in one of the first energy level and the second energy level following application of the input signal and the plurality of control signals. Which of the first and second energy levels is used to determine the final population will be the other of the first and second energy levels from that which the first population was transferred into in step S10. The final population may be determined as a proportion of an initial population in the other of the first energy level and the second energy level prior to application of the input signal and the control signal. The initial population will be the population prior to steps S12 and S14 in whichever of the first and second energy levels the first population was transferred into in step S10. In this way, the transition probability for each control signal (or each sensing region) can be determined using the final population.

The final population may be determined by considering where the fluorescence measured in step S16 falls between the two extremes corresponding to 10) or | $\pm$ 1). For example, if the measurement in step S16 is close to the highest values, this indicates that substantially all of the electrons initially in the one of the first and second energy levels were transferred into the other of the first and second energy levels by the combination of the input signal and control signal in steps S12 and S14 (as illustrated in the example of Fig. 5). Therefore, the corresponding transition probability is large. Conversely, if the measurement in step S16 is close to the lowest value, this indicates that little or no population of electrons was transferred (as illustrated in the example of Fig. 6), and the corresponding transition probability will be small. In some embodiments, the change in measured photoluminescence depends linearly on the proportion of the population transferred.

Once the transition probabilities have been determined, the method comprises a step S20 of calculating the amplitude and/or frequency of the input signal using the plurality of transition probabilities. In the apparatus 10, the processor 18 is configured to carry out this calculation. As mentioned above, the properties of the input signal relative to the properties of the control signals and the first transition frequency will determine what proportion of electrons are transferred between the first and second energy levels. Therefore, the transition probabilities can be used to determine the properties of the input signal.

Calculating the amplitude and/or frequency of the input signal comprises fitting to the plurality of determined transition probabilities a dependence of the transition probability on the amplitude and frequency of the input signal and on the amplitude and frequency of the control signal. In general, the dependence of the transition probability will be different depending on the properties of the material 12 and the exact energy level structure within the material 12.

In the specific example of the NV centre discussed above, the dependence of the transition probability P may be given by:

$$P = \frac{\widetilde{\Omega}^2}{(\Delta_+ - \Delta_-)^2 + \widetilde{\Omega}^2} \sin^2\left(\frac{t}{2}\sqrt{(\Delta_+ - \Delta_-)^2 + \widetilde{\Omega}^2}\right)$$

wherein:

$$\widetilde{\Omega} = \frac{\Omega_+ \Omega_-}{\Delta_+ + \Delta_-}$$

and wherein $\Omega_+$ and $\Omega_-$ are the amplitudes of the input signal and control signal respectively, $\Delta_+$ is a difference between the frequency of the input signal and a first transition frequency between the first energy level and the third energy level, $\Delta_-$ is a difference between the frequency of the control signal and a second transition frequency between the second energy level and the third energy level, and t is a time for which both the input signal and the control signal are simultaneously applied to the material.

This equation applies in a regime where the input signal and control signals have detunings $\Delta_+$ and $\Delta_-$ from the first and second transition frequencies that are much greater than their amplitudes $\Omega_+$ and $\Omega_-$. However, the method may also be used in other regimes, for example with much larger amplitudes of the control signals and/or input signal, in which a different dependence of the transition probability would be appropriate. It is assumed that the input signal and output signals have constant amplitudes $\Omega_+$ and $\Omega_-$, but in general the input signal amplitude may vary. The transition probability depends on the amplitude and frequency of both the input signal and the control signals provided by the signal generator 28. This enables the spectral analysis of the input signal.

Superimposed on the material 12 in Fig. 1 is a graph showing the continuous dependence of the transition probability P on both the detuning $\Delta_-$ of the control signals from the second transition frequency, and the amplification of the input signal. The apparatus 10 will calculate a plurality of transition probabilities from the measurements of the property of the material 12 at each crossing point between the input lines 32 and control lines 30. The plurality of transition probabilities will correspond to the values shown in the graph at each crossing point between the input and control lines 32, 30.

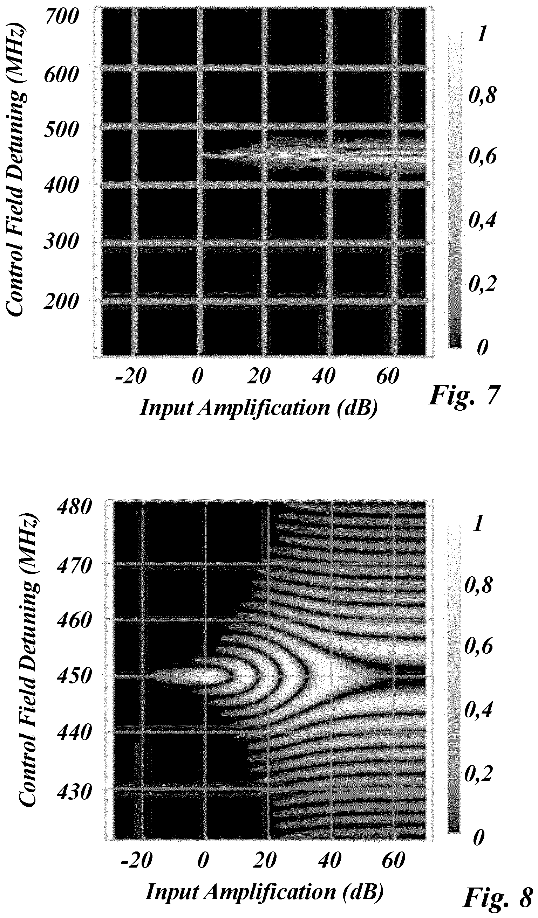

Figs. 7 and 8 shows further examples of calculated transition probabilities. As shown in Fig. 7, increasing the measurement time (i.e., the time for which the input and control signals are simultaneously applied to the material 12) and reducing the control field power leads to narrower spectral features on the device. This allows a wide bandwidth of frequencies to be scanned to find the approximate frequency range of the input signal. As shown in Fig. 8, the detuning of the control signals can then be selected appropriately to more precisely resolve the features (note vertical scale change between Fig. 7 and Fig. 8).

By fitting the equation above (or another equation which is appropriate in the regime in which the apparatus 10 is operated) to the transition probabilities determined at each crossing point (i.e. for each sensing region of the material 12) using the known values of the control signal detuning and control signal amplitude, the input signal detuning (and therefore frequency) and amplitude can be calculated.

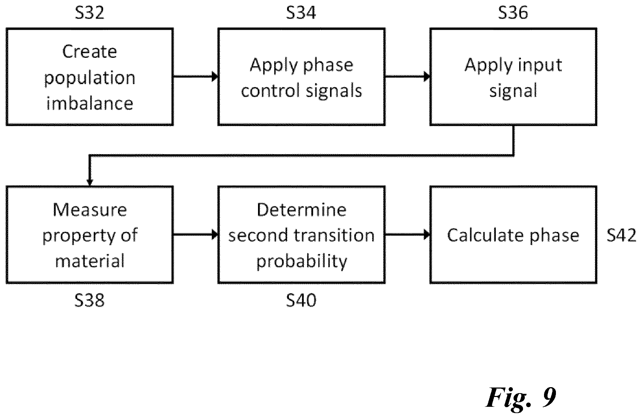

Following the step of calculating the amplitude and/or frequency of the input signal, it may also be desirable to carry out a step S30 of determining the phase of the input signal. Step S30 comprises a number of sub-steps, as shown in Fig. 9. The phase can be measured using the polarization dependence of a single transition, e.g. either the transition between the first and third energy levels, or the transition between the second and third energy levels.

For example, in the NV centre, the transition between the first and third energy levels 10) $\leftrightarrow$ |+1⟩ has circular polarization $\sigma+$, such that the plane in which the magnetic field vector rotates is transverse to the N-V axis within the NV centre. The magnetic field created by a wire (such as the input lines 32 and control lines 30 in the apparatus 10) has linear polarization. Aside from pathological cases, this linear field will have a non-zero projection on the desired plane (the plane in which the magnetic field vector rotates for the polarization of the relevant transition), which is known from the chosen geometry of the apparatus 10.

The geometrical parameters are set by the crystallographic orientation of the NV centres, the depth of the NV centres within the material 12 below the control and input lines 30, 32 on the surface of the material 12, and the transverse distance of the NV centres to the control and input lines 30, 32. The geometry can be chosen such that the control line 30 and input line 32 where they cross within each sensing region create oscillating magnetic fields with orthogonal orientations in the desired plane.

For example, NV centres orientated vertically to the surface of the material 12 and placed at a depth within the material 12 comparable to their transverse distance from the crossing between the control line 30 and input line 32 in the nearest sensing region will fulfil the geometrical requirements. Adjusting the relative phase of the input signal and control signal then allows the polarization of the overall applied field to be rotated through all linear, circular and elliptical polarizations.

Alternatively, the NV centres can be arranged so that the fields from the control line 30 and input line 32 have the same linear polarization. For example, NV centres with their axis in the plane of the material 12 and placed close to the surface of the material 12. Then, the input signals and control signals will simply interfere constructively or destructively, depending on their relative phase.

Varying the phase of the input and control signals can be achieved by placing phase shifters on the input to the control lines 30 and input lines 32. The phase shifters may be controlled by the controller 14. Depending on the operation of the signal generator 28, the control signal phases may alternatively or additionally be varied by changing the waveforms generated by the signal generator 28. If the phase of all N amplified input signals and M control signals can be varied, the relative phase of the input signal can be measured with N×M values.

The first sub-step S32 is the same as the step S10. The material 12 is initialised by creating a population imbalance between the first energy level and the second energy level. For example, by transferring a first population into one of the first energy level and the second energy level.

Subsequently, the step S36 comprises applying the input signal to the material 12. This is similar to the step S14 described above. However, the step differs where a plurality of input lines 32 are used, and applying the input signal to the material 12 comprises applying the input signal to the plurality of input lines 32 on the material 12. Instead of splitting the input signal into a plurality of amplified input signals with different amplification factors, the input signal is instead phase shifted before application to each input line 32 by a phase factor that is different for each input line 32. This may comprise splitting the input signal into a plurality of phase-shifted input signals, which are each phase shifted relative to the input single by a different phase factor.

The step S34 comprises applying a plurality of phase control signals to the material 12. This is similar to step S12 described above, and each phase control signal drives transitions between the second energy level and the third energy level. However, each phase control signal has a frequency that differs by a predetermined frequency difference from the calculated frequency of the input signal from step S20, and has a phase shift different from a phase shift of any other phase control signal. Therefore, each phase control signal comprises the same signal phase shifted by a phase factor that is different for each phase control signal.

When the predetermined frequency difference is non-zero, this constitutes a heterodyne measurement. This may be preferred in some implementations, for example if there is a need to correct for a DC offset or low-frequency noise. In some embodiments, the predetermined frequency difference is zero. This constitutes a homodyne measurement.

The phase control signals may be generated in any suitable way. For example, a signal generated by the signal generator 28 may be split into a plurality of phase control signals, and phase shifters used to apply the phase factors to each phase control signal. Alternatively, the signal generator 28 may directly generate a plurality of phase control signals having different phase factors.

In Fig. 9, the step S36 of applying the input signal is performed after the step S34 of applying the control signal. As for Fig.4, these steps may in general be performed in any order, or performed simultaneously. However, there must be a period of time during which both the input signal and phase control signals are simultaneously applied to the material 12. Preferably the phase control signals are switched on before the input signal is applied, and switched off after the input signal is no longer being applied. This improves detection efficiency by ensuring that measurements can be made for the entire duration of the input signal.

Step S38 comprises measuring the property of the material 12. This is carried out in a similar manner as described for step S16 above. However, in contrast to step S16, no process of transferring electrons from the other of the first energy level and the second energy level to the third energy level using a microwave pulse is needed. This is because, the phase is determined using a single transition, and both input signal and phase control signals have the same frequency. The interference between the input signal and phase control signal determines the total amplitude applied to the material 12, and therefore determines the driving transitions between the one of the first and second energy levels, and the third energy level. Since the fluorescence measures the population in the third energy level, there is no need to carry out any transfer of population after the input signal and phase control signals are applied.

Step S40 comprises determining a phase transition probability for each phase control signal using the measurements of the property of the material 12. The phase transition probability is a probability of transitions between the one of the first energy level and the second energy level, and the third energy level under application of the input signal and the phase control signal. This is carried out in a similar manner to step S18. The transition probability can be determined using a final population in the third energy level following application of the input signal and phase control signals. The final population may be determined as a proportion of an initial population in the one of the first energy level and the second energy level into which the first population was transferred in step S32.

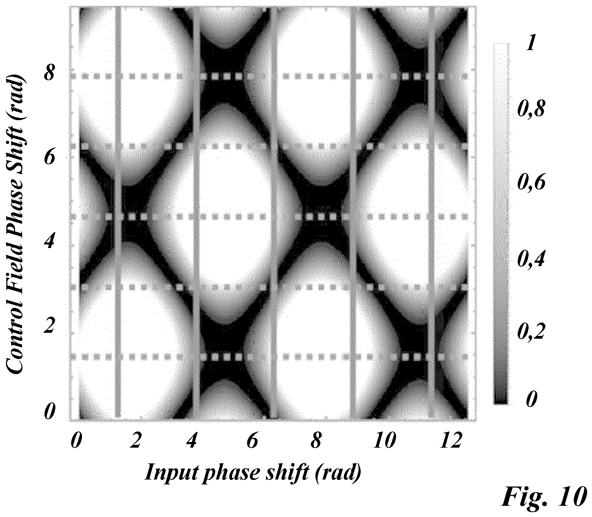

In step S42, the phase of the input signal is calculated using the plurality of phase transition probabilities. As for step S20, this may comprise fitting a dependence of the phase transition probability on the phase of the input signal and phase control signals to the measurements of the property of the material obtained in step S38. Fig. 10 is an exemplary contour plot showing the continuous dependence of the phase transition probability versus the phases of the input signal and phase control signals. The measurements made in step S38 will reflect the values at the crossing positions of the control and input lines 30, 32 in the sensing regions. Having already determined the amplitude and frequency of the input signal, following step S42, the input signal is fully characterized in terms of its amplitude, frequency, and phase.

In the method outlined above, the resolution with which the frequency of the input signal can be determined is limited by the frequency spacing chosen between the control signals and the control lines 30. This is limited only by the precision of the frequency generator available. When NV centres are used, their linewidth also affects the resolution.

However, using the double transition method outlined above, this linewidth can be narrower than that of either single transition. This is particular true in isotopically purified diamond, since the linewidth of single transitions is disturbed in part by common-mode noise which does not broaden the double-quantum transition.

Additionally, the method does not require a magnetic field gradient at all, in contrast to gradient-based methods previously mentioned. The apparatus 10 can be operated at a single magnetic field bias value for which the nuclear spins are polarized during optical initialization. The magnetic field value can be small, and chosen to optimise the properties of the material 12 with respect to the first and second transitions. For example, at a magnetic field value of 0.05 T, the system displays the narrowest linewidths of the double transition and no undesired hyperfine-split transitions.

The measurement bandwidth of the apparatus 10 may be limited to approximately 1 GHz by the condition that the values of the input signal and control field detunings $\Delta$ and the values of the input signal and control signal amplitudes Q must be significantly smaller than the first and second transition frequencies. Outside of these constraints, the simple analytical expression given for the transition probability above is not valid. However, the measurement bandwidth can be extended into the tens of GHz by using multiple iterations of the apparatus 10 with different magnetic bias fields. For higher bias fields, the nuclear spin is no longer polarized, which causes decreased measurement contrast. However, this drawback can be overcome by repetition of the measurements. The apparatus 10 can further be used for the detection of multiple input signals simultaneously.

For materials such as the diamond crystal containing NV-centres, where the spacing of the energy levels is dependent on the applied magnetic field, the apparatus 10 can also be used to measure magnetic fields. Consequently, there is further provided a method of measuring a magnetic field applied to a material using measurements of a property of the material 12.

The property of the material 12 is dependent on a population in at least one of a first energy level, a second energy level, and a third energy level within the material 12.

As for the method of analysing the input signal, direct transitions are permitted between the first energy level and the third energy level, direct transitions are permitted between the second energy level and the third energy level, and direct transitions are not permitted between the first energy level and the second energy level.

In addition, at least one of (a) a first transition frequency between the first energy level and the third energy level, and (b) a second transition frequency between the second energy level and the third energy level, is dependent on the strength of the magnetic field. In the case of the NV centre, both the first transition frequency and the second transition frequency depend on the magnetic field, but this is not essential.

The method comprises applying an input signal to the material, the input signal driving transitions between the first energy level and the third energy level. The method further comprises applying one or more control signals to the material, the control signals driving transitions between the second energy level and the third energy level.

In the signal analysis method, there are two unknowns that can affect the transition probabilities (the amplitude and frequency of the input signal). Therefore, a plurality of control signals are needed to provide at least two sets of data to fit the two unknowns. However, for the magnetic field measurements, there is only one unknown (the magnetic field strength), so a minimum of one control signal is needed.

The method further comprises measuring the property of the material 12.

All of these steps are conducted in substantially the same way as for the method of analysing the input signal discussed above. The difference in this method is that the properties of the input signal are known in addition to the properties of the control signals. However, the strength of the magnetic field is unknown. All of the details of the implementation of the signal analysis method are equally applicable to the magnetic field measurement method. The exception is the phase measurement details, which are not applicable to the magnetic field measurement.

The method further comprises determining a transition probability for each control signal using the measurements of the property of the material. The transition probability is a probability of transitions between the first energy level and the second energy level under application of the input signal and the control signal. Finally, the method comprises calculating the strength of the magnetic field using the plurality of transition probabilities.

Since the first and second transition frequencies are dependent on the magnetic field as well as the properties of the input signal and control signals, the magnetic field can be deduced from the transition probabilities determined from the measurements of the property of the material 12 and the known properties of the input and control signals. For example, in the case of the NV-centre, the splitting of the $|\pm 1\rangle$ spin levels is dependent on the magnetic field. Therefore, the probability transition between the first and second energy levels at given frequency and amplitude will depend on the magnetic field.

Each point on the material at which the input signal and control signal are simultaneously applied will provide a measurement of magnetic field. Therefore, a minimum of one control signal is required. However, using a grid of input wires and control wires, as shown in the apparatus 10 of Fig. 1, can improve the certainty in the result magnetic field. Additionally or alternatively, if the magnetic field varies over the material, the apparatus allows high-resolution measurements of the magnetic field at a plurality of points over an area. Unlike in the method of analysing an input signal, there is no requirement for the control signals to differ from one another.

**Claims**

1. A method of analysing an input signal using measurements of a property of a material (12), wherein:

   the property of the material (12) is dependent on a population in at least one of a first energy level, a second energy level, and a third energy level within the material (12);
   direct transitions are permitted between the first energy level and the third energy level;
   direct transitions are permitted between the second energy level and the third energy level; and
   direct transitions are not permitted between the first energy level and the second energy level;
   the method comprising:

   applying the input signal to the material (12), the input signal driving transitions between the first energy level and the third energy level;
   applying a plurality of control signals to the material (12), each control signal having a frequency different from the frequencies of the other control signals, the control signals driving transitions between the second energy level and the third energy level;
   measuring the property of the material (12);
   determining a transition probability for each control signal using the measurements of the property of the material (12), the transition probability being a probability of transitions between the first energy level and the second energy level under application of the input signal and the control signal; and
   calculating the amplitude and/or frequency of the input signal using the plurality of transition probabilities.

2. The method of claim 1, wherein:

   (a) the input signal has a frequency that differs from a first transition frequency between the first energy level and the third energy level by at most a first predetermined value; and/or
   (b) the frequency of each of the plurality of control signals differs from a second transition frequency between the second energy level and the third energy level by at most a second predetermined value.

3. The method of any preceding claim, wherein applying the input signal to the material (12) comprises:

   splitting the input signal into a plurality of amplified input signals, each amplified input signal being amplified by an amplification factor relative to the input signal, the amplification factor being different for each amplified input signal; and
   applying the plurality of amplified input signals to the material (12).

4. The method of claim 3, wherein:

   the plurality of control signals are applied to a respective plurality of sensing regions of the material (12), and measuring the property of the material (12) comprises measuring the property of the material (12) in each of the sensing regions; and
   the application of the plurality of control signals and the plurality of amplified input signals is performed such that the combination of the frequency of the control signal and the amplification factor of the amplified input signal is different for each sensing region.

5. The method of any preceding claim, further comprising, prior to applying the input signal and the plurality of control signals, creating a population imbalance between the first energy level and the second energy level.

6. The method of claim 5, wherein creating the population imbalance between the first energy level and the second energy level comprises transferring a first population into one of the first energy level and the second energy level, optionally wherein transferring the first population into one of the first energy level and the second energy level comprises optically exciting a second population into an excited state.

7. The method of claim 6, wherein transferring the first population into one of the first energy level and the second energy level further comprises, following the optical excitation of the second population, transferring the first population from the third energy level into the one of the first energy level and the second energy level.

8. The method of claim 7, wherein the property of the material (12) is dependent on the population in the third energy level, and measuring the property of the material (12) comprises, following application of the input signal and the plurality of control signals, transferring a third population from the other of the first energy level and the second energy level to the third energy level.

9. The method of any preceding claim, wherein the control signals and/or the input signal are pulsed, optionally wherein measuring the property of the material (12) comprises measuring the property of the material (12) between pulses of the control signals and/or the input signal.

10. The method of any preceding claim, wherein determining the transition probability for each control signal comprises determining, using the measurements of the property of the material (12), a final population in one of the first energy level and the second energy level following application of the input signal and the plurality of control signals.

11. The method of claim 10, wherein the final population is determined as a proportion of an initial population in the other of the first energy level and the second energy level prior to application of the input signal and the control signal, optionally wherein the transition probability for each control signal is determined using the final population.

12. The method of any preceding claim, wherein calculating the amplitude and/or frequency of the input signal comprises fitting to the plurality of determined transition probabilities a dependence of the transition probability on the amplitude and frequency of the input signal and on the amplitude and frequency of the control signal, optionally wherein the dependence of the transition probability P is given by:

$$P = \frac{\widetilde{\Omega}^2}{(\Delta_+ - \Delta_-)^2 + \widetilde{\Omega}^2} \sin^2\left(\frac{t}{2}\sqrt{(\Delta_+ - \Delta_-)^2 + \widetilde{\Omega}^2}\right)$$

wherein:

$$\widetilde{\Omega} = \frac{\Omega_+ \Omega_-}{\Delta_+ + \Delta_-}$$

and wherein $\Omega_+$ and $\Omega_-$ are the amplitudes of the input signal and control signal respectively, $\Delta_+$ is a difference between the frequency of the input signal and a first transition frequency between the first energy level and the third energy level, $\Delta_-$ is a difference between the frequency of the control signal and a second transition frequency between the second energy level and the third energy level, and t is a time for which both the input signal and the control signal are simultaneously applied to the material (12).

13. The method of any preceding claim, further comprising, following the step of calculating the amplitude and/or frequency of the input signal:

applying the input signal to the material (12);
applying a plurality of phase control signals to the material (12), wherein each phase control signal (a) drives transitions between one of the first energy level and the second energy level, and the third energy level, (b) has a frequency that differs by a predetermined frequency difference from the calculated frequency of the input signal, and (c) has a phase shift different from a phase shift of any other phase control signal;
measuring the property of the material (12);
determining a second transition probability for each phase control signal using the measurements of the property of the material (12), the second transition probability being a probability of transitions between the one of the first energy level and the second energy level, and the third energy level under application of the input signal and the phase control signal; and
calculating the phase of the input signal using the plurality of second transition probabilities.
optionally wherein applying the input signal to the material (12) comprises applying the input signal to a plurality of input lines (32) on the material (12), the input signal being phase shifted before application to each input line (32) by a phase factor that is different for each input line (32).

14. An apparatus (10) for analysing an input signal comprising:

a material (12) having a property dependent on a population in at least one of a first energy level, a second energy level, and a third energy level within the material (12), wherein direct transitions are permitted between the first energy level and the third energy level, direct transitions are permitted between the second energy level and the third energy level, and direct transitions are not permitted between the first energy level and the second energy level;

a controller (14) configured to apply the input signal to the material (12), the input signal driving transitions between the first energy level and the third energy level, and apply a plurality of control signals to the material (12), each control signal having a frequency different from the frequencies of the other control signals, the control signals driving transitions between the second energy level and the third energy level;

a detector (16) configured to measure the property of the material (12); and

a processor (18) configured to determine a transition probability for each control signal using the measurements of the property of the material (12), the transition probability being a probability of transitions between the first energy level and the second energy level under application of the input signal and the control signal, and calculate the amplitude and/or frequency of the input signal using the plurality of transition probabilities.

15. A method of measuring a strength of a magnetic field applied to a material (12) using measurements of a property of the material (12), wherein:

the property of the material (12) is dependent on a population in at least one of a first energy level, a second energy level, and a third energy level within the material (12);

direct transitions are permitted between the first energy level and the third energy level;

direct transitions are permitted between the second energy level and the third energy level;

direct transitions are not permitted between the first energy level and the second energy level; and

at least one of (a) a first transition frequency between the first energy level and the third energy level, and (b) a second transition frequency between the second energy level and the third energy level, is dependent on the strength of the magnetic field,

the method comprising:

applying the input signal to the material (12), the input signal driving transitions between the first energy level and the third energy level;

applying one or more control signals, preferably a plurality of control signals, to the material (12), the control signals driving transitions between the second energy level and the third energy level;

measuring the property of the material (12);

determining a transition probability at each measurement position using the measurements of the property of the material (12), the transition probability being a probability of transitions between the first energy level and the second energy level under application of the input signal and the control signal; and

calculating the strength of the magnetic field using the one or more transition probabilities.

16. An apparatus (10) for measuring a magnetic field applied to a material (12) the apparatus comprising:

the material (12) having a property dependent on a population in at least one of a first energy level, a second energy level, and a third energy level within the material (12), wherein direct transitions are permitted between the first energy level and the third energy level, direct transitions are permitted between the second energy level and the third energy level, direct transitions are not permitted between the first energy level and the second energy level, and at least one of (a) a first transition frequency between the first energy level and the third energy level, and (b) a second transition frequency between the second energy level and the third energy level, is dependent on the strength of the magnetic field,

a controller (14) configured to apply the input signal to the material (12), the input signal driving transitions between the first energy level and the third energy level, and apply one or more control signals, preferably a plurality of control signals, to the material (12), the control signals driving transitions between the second energy level and the third energy level;

a detector (16) configured to measure the property of the material (12); and

a processor (18) configured to determine a transition probability for each control signal using the measurements of the property of the material (12), the transition probability being a probability of transitions between the first energy level and the second energy level under application of the input signal and the control signal, and calculate the strength of the magnetic field using the one or more transition probabilities.

**Fig. 1**

**Fig. 2**

**Fig. 3**

S10             S12             S14

| Create population imbalance | Apply control signals | Apply input signal |

| Measure property of material | Determine transition probability | Calculate amplitude and/or frequency | S20 |

S16             S18

| Determine phase |

S30

*Fig. 4*

*Fig. 5*

*Fig. 6*

Fig. 7

Fig. 8

S32                          S34                          S36

| Create population imbalance | → | Apply phase control signals | → | Apply input signal |

| Measure property of material | → | Determine second transition probability | → | Calculate phase | S42

S38                          S40

*Fig. 9*

*Fig. 10*

## EUROPEAN SEARCH REPORT

Europäisches
Patentamt
European
Patent Office
Office européen
des brevets

**Application Number**

EP 23 17 9498

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2017 205265 A1 (BOSCH GMBH ROBERT [DE]) 4 October 2018 (2018-10-04) | 1,2, 5-12, 14-16 | INV. G01R29/08 G01R33/032 |
| A | * paragraphs [0002] - [0008], [0028] - [0064]; claims 1-12; figures 1-16 * ----- | 3,4,13 | G01R33/12 |
| X | JOHN F BARRY ET AL: "Sensitivity Optimization for NV-Diamond Magnetometry", ARXIV.ORG, CORNELL UNIVERSITY LIBRARY, 201 OLIN LIBRARY CORNELL UNIVERSITY ITHACA, NY 14853, 28 May 2020 (2020-05-28), XP081663273, DOI: 10.1103/REVMODPHYS.92.015004 | 1,2, 5-12, 14-16 | |
| A | * claims 1-35; figures 1-27 * ----- | 3,4,13 | |
| X | US 2017/146617 A1 (STETSON JR JOHN B [US] ET AL) 25 May 2017 (2017-05-25) | 1,2, 5-12, 14-16 | |
| A | * paragraphs [0034] - [0060]; claims 1-21; figures 1-9 * ----- | 3,4,13 | |
| A | US 2022/155243 A1 (BLANK AHARON [IL] ET AL) 19 May 2022 (2022-05-19) * the whole document * ----- | 1-16 | **TECHNICAL FIELDS SEARCHED (IPC)** G01R |

The present search report has been drawn up for all claims

| Place of search | Date of completion of the search | Examiner |
|---|---|---|
| Munich | 29 November 2023 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 9498

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2023

| Patent document cited in search report | Publication date | Patent family member(s) | | Publication date |
|---|---|---|---|---|
| DE 102017205265 A1 | 04-10-2018 | DE 102017205265 A1 | | 04-10-2018 |
| | | FR 3064752 A1 | | 05-10-2018 |
| US 2017146617 A1 | 25-05-2017 | US 2017146617 A1 | | 25-05-2017 |
| | | WO 2017087014 A1 | | 26-05-2017 |
| US 2022155243 A1 | 19-05-2022 | NONE | | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **L RONDIN et al.** *Rep. Prog. Phys.*, 2014, vol. 77, 056503